# EUROPEAN PATENT SPECIFICATION

(11) **EP 4 269 724 B1**
(45) Date of publication and mention of the grant of the patent: **21.01.2026**
(21) Application number: 23164988.0
(22) Date of filing: 29.03.2023
(51) Int. Cl.: E04H 5/02, H05K 7/14, B65D 90/00

(54) **PORTABLE DATA CENTRE MODULE**
TRANSPORTIERBARES RECHENZENTRUMSMODUL
MODULE DE CENTRE DE DONNÉES TRANSPORTABLE

(30) Priority: 25.04.2022 GB 202205971
(43) Date of publication of application: 01.11.2023
(73) Proprietor: KES Group Inc Limited, Strabane County Tyrone BT82 9GU (GB)
(72) Inventor: MULLAN, Brandon, Dungiven BT82 9GU (GB)
(74) Representative: FRKelly

(56) References cited:
- US-B1- 10 143 105
- US-B2- 8 210 488

## Description

### FIELD OF THE INVENTION

This invention relates to a portable building and in particular to a prefabricated portable data centre module.

### BACKGROUND OF THE INVENTION

IT companies and cloud service providers have an urgent need to rapidly build and commission new data centres to meet ever increasing demand. However, many organizations are finding it harder to complete their data centre requirements on time and within budget. In addition to labour shortages, traditional brick and mortar construction methods introduce numerous other operational challenges, such as budgeting constraints, construction delays, site waste and other factors that can extend the construction timeline. In order to speed up installation, manage costs and lay an extensible foundation that can evolve quickly with new technology, more data centre owners are taking a modular approach to construction and turning to prefabricated portable data centre solutions.

Portable data centre modules are prefabricated cabins that are supplied fully equipped with computer equipment and power supply systems before being transported to the point of use and installed on site by lifting into the required position. Portable data centre modules can be installed and commissioned much more quickly and easily than using traditional onsite construction methods and at a lower cost. They can also provide greater reliability, because every component installed in a modular data centre can be thoroughly tested during manufacture and assembly, and can have significantly lower power consumption than brick and mortar data centres because of the module's compact size and the fact that all of the components are exactly matched. Furthermore, because a portable data centre module is more compact and self-contained, it is easier to secure.

Known portable data centre modules are typically built into shipping containers to facilitate transportation and provide a secure weatherproof enclosure for the sensitive equipment contained therein.

However, standard shipping containers are not designed to deal with the very specific demands of the highly sensitive electronic equipment contained within such data centre modules. In particular, normal frame deflections of a shipping container during lifting using conventional lifting eyes can often lead to damage to the highly sensitive equipment located within a data centre module. The highly sensitive equipment which is housed within such portable data centre modules prior to delivery to site require stricter constraints on frame deflections than what is generally used in structural engineering design. Typically for a standard shipping container, vertical deflections of approximately 12mm (corresponding to a span to deflection ratio of 250) would be acceptable for service conditions. However to prevent the risk of any damage being caused to the equipment within a portable data centre module, vertical deflections should be limited to 3mm under the plate flooring of the module. This restriction poses significant problems during installation of such known portable data centre modules, particular at height.

US 8,210,488 discloses a known lifting structure for a portable building.

### SUMMARY OF THE INVENTION

According to the present invention there is provided a portable data centre module as claimed in claim 1.

Each lifting member comprises a metal plate dimensioned to fit between upper and lower flanges of the respective C section support beam within which the respective lifting member is mounted. Preferably a vertical slot is provided in a rear wall of the respective side beam, aligned with a respective support beam and through which the respective lifting member extends. Each lifting member is preferably supported in a series of longitudinally spaced steel guide plates, each guide plate having a respective slot formed therein through which the respective lifting member passes. An outermost guide plate may be mounted between the upper and lower flanges of the respective side beam of the floor platform at an outer side of the respective side beam.

A plurality of longitudinally spaced inner guide plates may be mounted within the "C" shaped section of the respective support beam adjacent the respective side beam. A stop pin may be provided adjacent an inner end of each lifting member, wherein that said stop pin is located between an adjacent pair of inner guide plates to delimit the extended and retracted positions of the respective lifting member with respect to the respective support beam, the stop pin abutting an outermost of said adjacent pair of guide plates when it is extended position and the stop pin abutting the innermost of said adjacent pair of guide plates when the lifting member is in its retracted position.

Each lifting plate may comprise a steel plate having a thickness of 25mm.

Preferably the lifting members do not project more than 210mm from the sides of the module when in their extended positions.

There may be further provided a lifting frame adapted to be located above the module and having lifting points in locations corresponding to the positions of the lifting members on the module, attachment straps terminating in lifting coupling extending from each lifting point of the lifting frame, said lifting couplings being adapted to be coupled to the lifting eyes of the lifting members when the lifting members are in their extended positions to permit the module be lifted.

### BRIEF DESCRIPTION OF THE DRAWINGS

A portable data centre module in accordance with an embodiment of the present invention will now be described, by way of example only, with reference to the accompanying drawings, in which:
Figures 1 and 2 are perspective views of the frame of a portable data centre module in accordance with an embodiment of the present invention with;
Figure 3 is a detailed perspective view of a lifting member of the data centre module of Figure 1 in an extended position;
Figure 4 is a detailed perspective view of a lifting member of the data centre module of Figure 1 in a retracted position;
Figure 5 is an exploded view of the lifting member components of the data centre module of Figure 1;
Figure 6 is a detailed perspective view of a lifting member of the data centre module of Figure 1 in the retracted position with parts of the module remove for clarity;
Figure 7 is a detailed perspective view of a lifting member of the data centre module of Figure 1 in the extended position with parts of the module remove for clarity;
Figure 8 is a further detailed perspective view of a lifting member of the data centre module of Figure 1 in the retracted position with parts of the module remove for clarity;
Figure 9 is a further detailed perspective view of a lifting member of the data centre module of Figure 1 in the extended position with parts of the module remove for clarity;
Figure 10 is a plan view of the floor of the data centre module of Figure 1 with the lifting members in their extended position; and
Figure 11 is a plan view of the floor of the data centre module of Figure 1 with the lifting members in their retracted position.

### DETAILED DESCRIPTION OF THE DRAWINGS

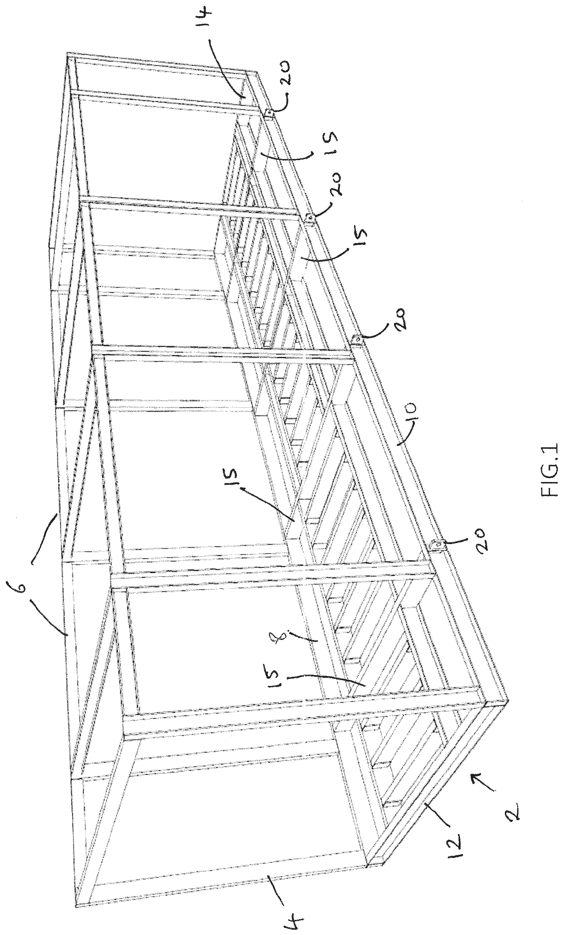

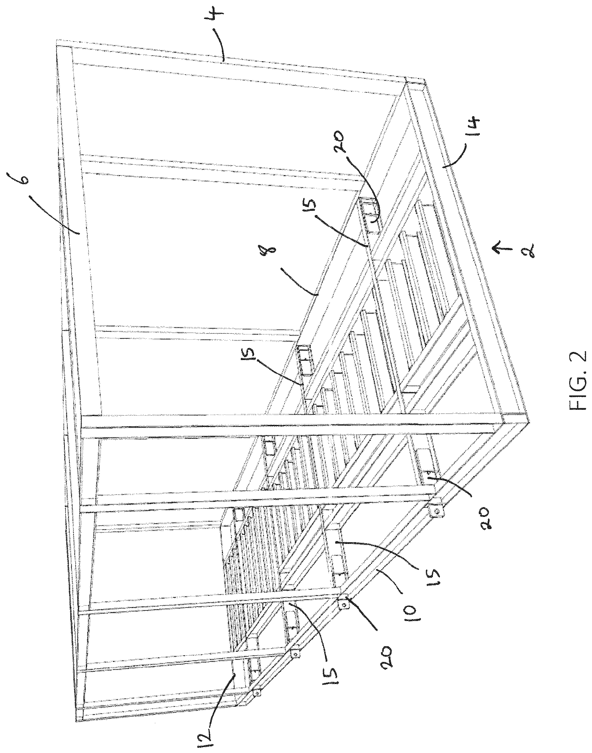

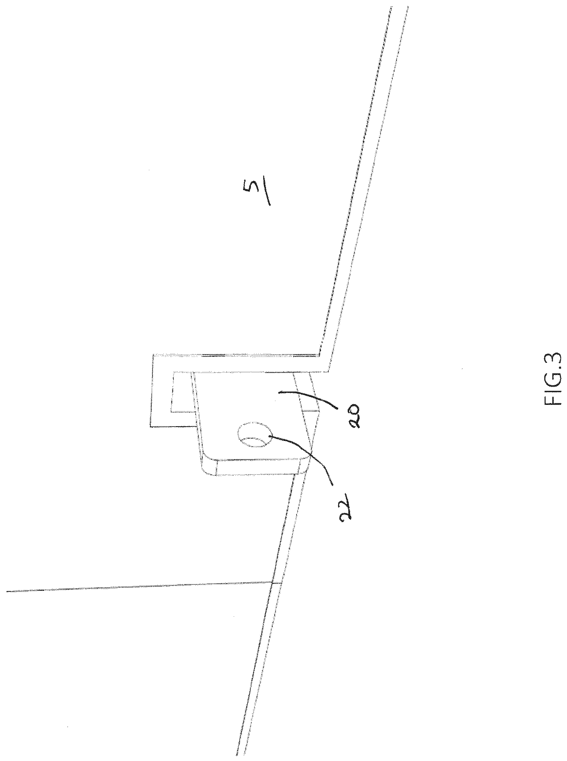

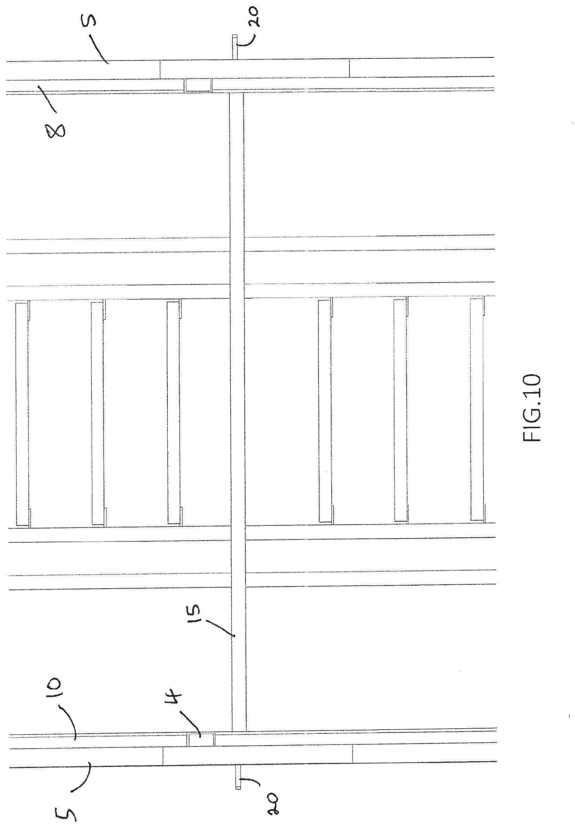

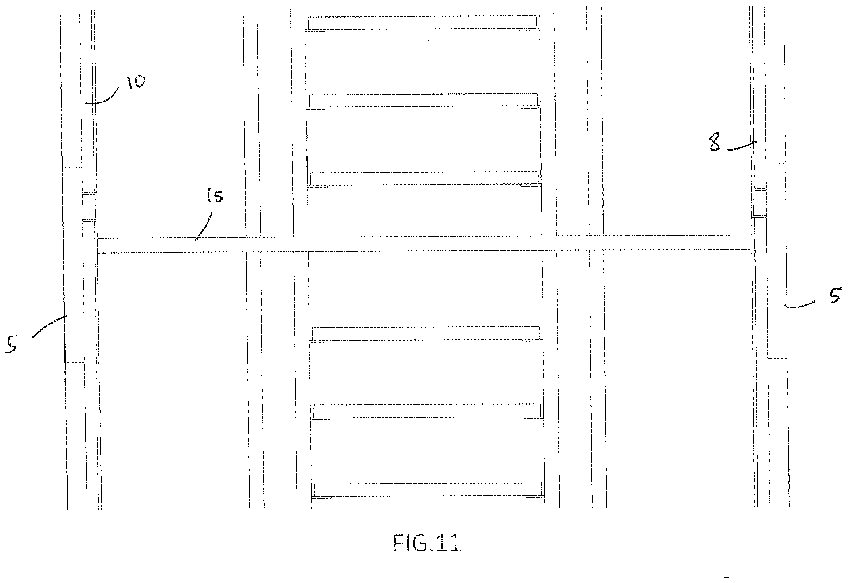

Figures 1 and 2 illustrate a portable data centre module in accordance with an embodiment of the present invention with the contents of the module and the contents, floor plates and roof and wall cladding removed to show the frame of the data centre module (Cladding 5 shown in Figure 3, 4, 10 and 11).

The frame of the module comprises a floor platform 2 upon which the floor plates (not shown) of the module are mounted. The floor platform 2 is formed from an arrangement of longitudinal and transversely extending "C" section steel beams welded together to form a strong and stiff base upon which the date centre equipment is supported. Upright wall beams 4 extend from the periphery of the floor platform at spaced locations therefrom to support wall cladding and roof beams 6 extend between the upper ends of the wall beams 4 to support roof cladding of the module.

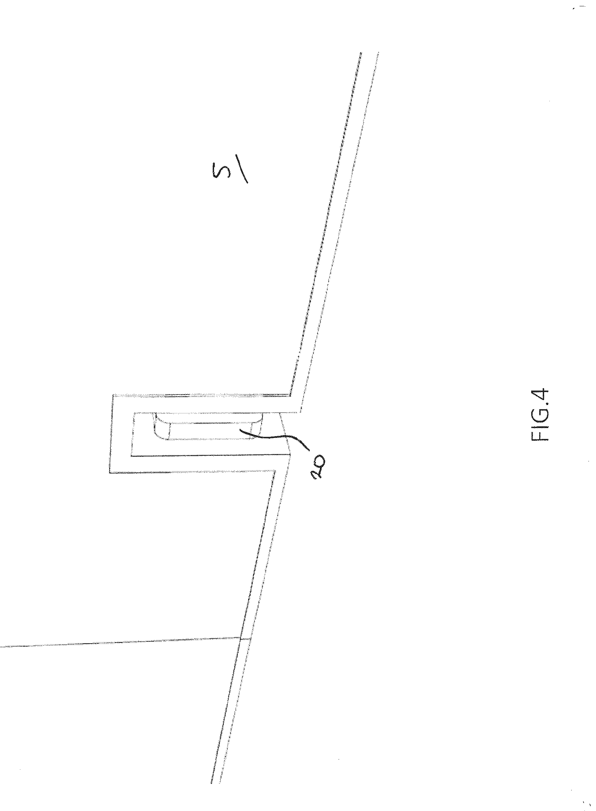

The floor platform 2 includes a pair of longitudinally extending side beams 8,10 extending along either side of the module, a pair of transversely extending end beams 12,14 at either end of the module and plurality of longitudinally spaced transversely extending support beams 15 extending between the side beams 8,10 and having lifting members 20 mounted in the ends thereof, a distal each lifting member 20 having an aperture defining a lifting eye 22 to which a lifting hook of a lifting frame (not shown) can be attached, as will be described below in more detail. The lifting members 20 are each retractably mounted in an end of a respective support beam 15 to be moveable between an extended position (as shown in Figure 3), wherein the lifting eyes 22 can be connected to a respective lifting hook of the lifting frame, and a retracted position (as shown in Figure 4), wherein the lifting members 20 are contained within the footprint of the module.

The structure of the floor platform 2, and in particular the position and construction of the support beams 15 and the lifting members 20 associated therewith, has been optimised to limit deformation of the floor plate on top of the floor platform 2 to no more that 3mm during transportation and lifting of the module.

To facilitate fabrication and detailing of the module, the depth of the lifting members 20 could not exceed that of the support beams 15 of the floor platform 2. In addition, the support beam locations and lifting member design have been carefully selected to suit lifting and transportation arrangements. Finally, the lifting members are retractably mounted within the support beams to enable them to be concealed within the floor platform, within the footprint of the module, when not in use.

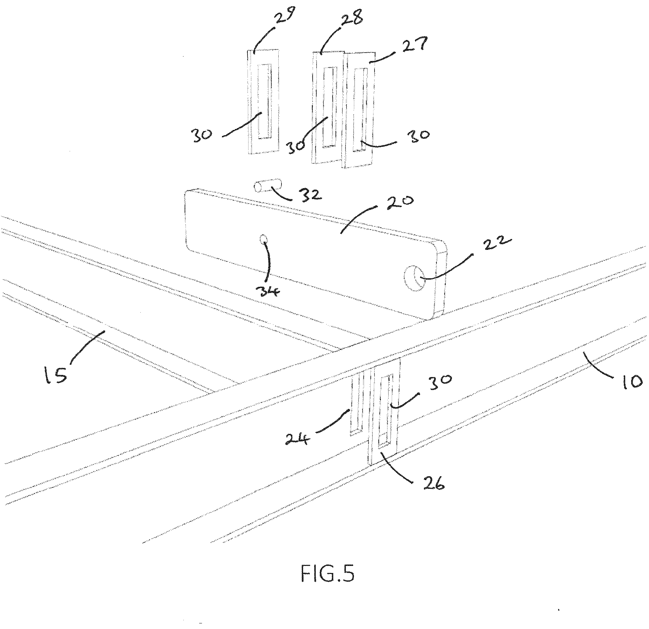

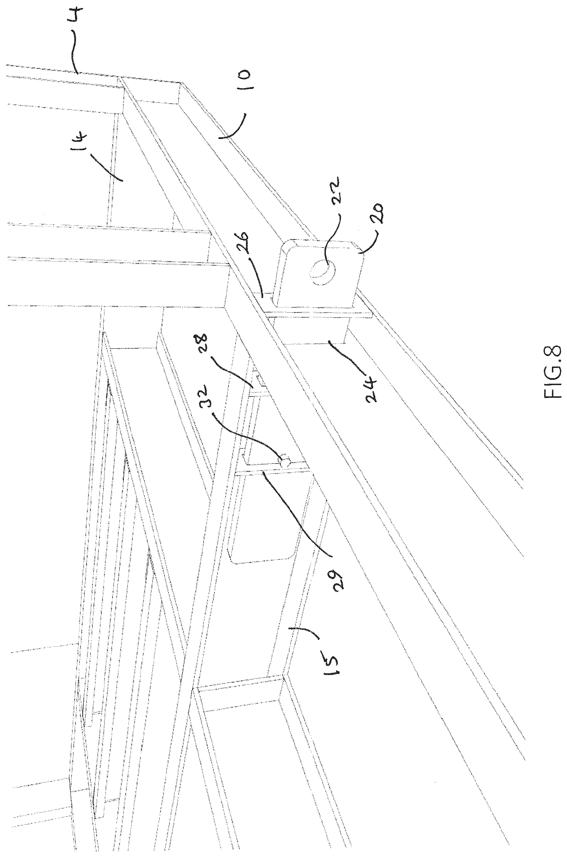

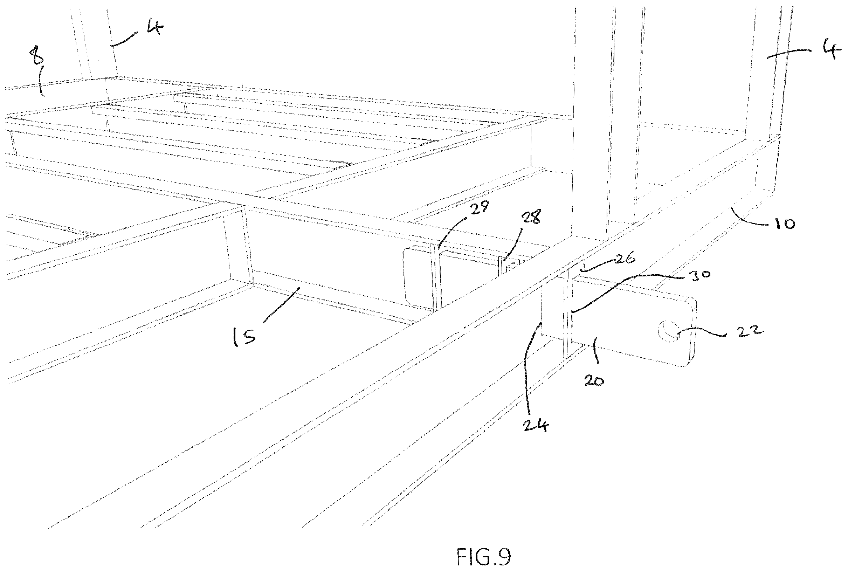

As best illustrated in Figures 5 to 9, each lifting member 20 comprises a metal plate dimensioned to fit between the upper and lower flanges of the respective C section support beam 15 within which the respective lifting member 20 is mounted.

As mentioned above, an aperture is provided in a distal end of the plate forming each lifting member 20 to define a lifting eye 22 for connecting the respective lifting member 20 to a lifting hook of a lifting frame via a suitable coupling when the lifting members are in their extended positions.

A vertical slot 24 is provided in a rear wall of the respective side beam 4,6, aligned with a respective support beam 15 and through which the respective lifting member 20 extends.

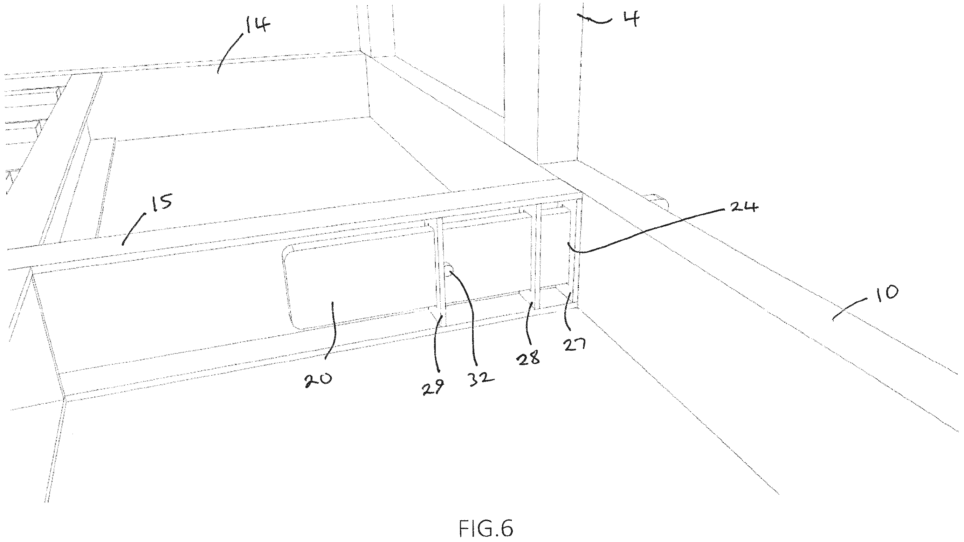

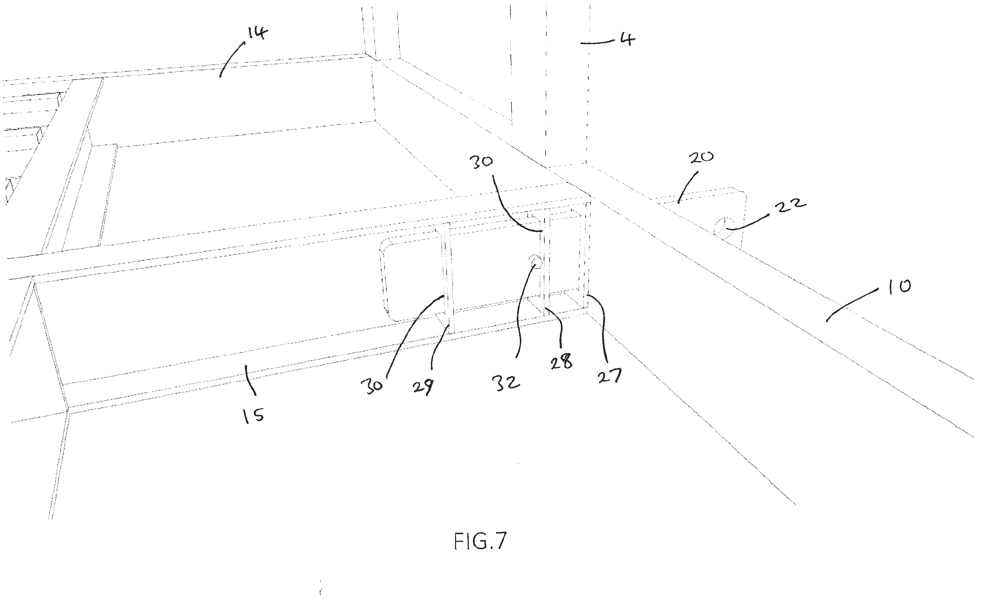

Each lifting member 20 is supported in a series of longitudinally spaced steel guide plates 26,27,28,29, each guide plate having a respective slot 30 formed therein through which the respective lifting member 20 passes. An outermost guide plate 26 is mounted (for example by welding) between the upper and lower flanges of the respective side beam 8,10 of the floor platform 2 at an outer side of the respective side beam 8,10. A series of inner guide plates 27,28,29 are mounted within the C shaped section of the respective support beam 15 adjacent the respective side beam 4,6, as best illustrated in Figures 6 and 7.

A stop pin 32 is provided adjacent an inner end of each lifting member 20, the stop pin 32 being secured in an aperture 34 through the respective lifting member 20, such that the stop pin 32 is located between an adjacent pair of guide plates 28,29 to delimit the extended and retracted positions of the respective lifting member 20 with respect to the respective support beam, the stop pin 32 abutting an outermost 28 of said adjacent pair of guide plates (as shown in Figure 7) when it is extended position and the stop pin 32 abutting the innermost 29 of said adjacent pair of guide plates (as shown in Figure 6) when the lifting member 20 is in its retracted position.

The lifting members 20 are designed considering the localised stresses within the support beams 15 during lifting operations, and are designed to be sufficiently stiff to transfer the loads from the lifting members 20 to the attached lifting hooks of the lifting frame. The highest shear forces in the support beams occur adjacent the distal ends of the support beams 15, and it has been determined that additional stiffening of the channel sections of the support beams 15 is required in such locations to prevent localised web buckling under maximum loads. The steel guide plates 27,28,29 provide this additional stiffening and have been robustly analysed to ensure they perform as efficiently as possible. The position of the guide plates 27,28,29 has been determined to provide stiffening where the stresses in the web of the support beams 15 are the highest, but to optimise material use, they were not located throughout the remainder of the length of the support beams 15, where web stresses diminish sufficiently. The guide plates 26,27,28,29 therefore serve a dual purpose; providing the necessary shear stiffness to the support beams 15 but also as guide plates for the lifting members 20. The guide plates provide restraint to the lifting members and detailed analysis of the local stresses around the slot 30 in each guide plate 26,27,28,29 was undertaken.

When the module is being lifted, the lifting members 20, in their extended positions, bear onto the guide plates 26,27,28,29, which creates localised bearing stresses around the slots 30 therein through which the lifting member 20 pass. The thickness of the guide plates 20 (preferably 25mm) was determined to ensure that these bearing stresses did not exceed the yield stress of the material.

The lifting members 20 were designed to meet the required design criteria using industry standard design codes and practices to ensure compliance with structural design practice. Stresses and strains in the support beams and lifting members were calculated using 3-D structural analysis tools and have been limited to ensure that the support beams and lifting members do not exceed their yield point during lifting of the date centre module.

Material factors were applied in accordance with Eurocodes to provide an additional factors of safety in the design. Through a rigorous analysis of the actions on the module during the lifting and transportation operations, the support beam locations along the length of the floor platform and the sizing of the support beams were refined to ensure that vertical deflections of the floor of the module were kept below the limits required.

The position of the guide plates 26,27,28,29 in the support beams 15 also serves to limit the travel distance of the lifting members 20 between their retracted and extended positions, preventing the lifting members 20 from slipping out of the support beams 15 when fully extended during lifting operations; whilst allowing sufficient retraction of the lifting members 20 when fully retracted such that the lifting members 20 are within the footprint of the module in such configuration. Therefore the guide plate locations were determined not only by the structural requirements, but have also been positioned to ensure sufficient travel of the lifting members towards their extended positions to allow a lifting frame to be fitted to the module.

The maximum projection of the each lifting member 20 from the sides of the module (preferably 210mm) has been optimised to facilitate ease of lifting whilst ensuring the structural design of the system is as efficient as possible. Travel of the lifting members 20 is limited through the use of the stop pins 32, which lock the respective lifting member 20 against an adjacent guide plate in both the lifting and retracted position. This element is critical in ensuring safety of the system during lifting operation, keeping the lifting members in place and preventing excessive stresses developing in the system which would occur if the lifting members 20 were permitted to project further than 210mm from the sides of the module.

Each lifting member 20 may be fabricated from 25mm thick steel plate, thereby providing sufficient rigidity to the system and ensuring no additional or excessive deformations occur. This system uniquely provides a robust yet adaptable means of lifting the modules whilst maintaining extremely low levels of vertical deflections during lifting operations.

In use, when it is desired to position the module in a location where it is intended to be used, a lifting frame, having an approximate footprint corresponding to the footprint of the module and having lifting point located to correspond to he positions of the lifting members of the module, lifting straps depending from each lifting point of the lifting frame and terminating in respective lifting hooks, is located above the module and the lifting hooks of the lifting frame are attached to the lifting eyes 22 of the lifting members 20 with the lifting member in their extended positions. The module can then be lifted by the lifting frame and positioned at the desired location.

Once installed in its desired location, the lifting hooks of the lifting frame are detached from the lifting eyes 22 and the lifting frame is moved away. The lifting members 20 are then moved to their retracted positions so that are stowed within the footprint of the module. The lifting members 20 may also be moved to their retracted positions during transportation of the module to minimise the width of the module and avoid damage to the lifting members 20 during transportation, for example on a trailer.

The invention is not limited to the embodiment described herein but can be amended or modified without departing from the scope of the present invention as defined by the appended claims.

## Claims

1. A portable data centre module comprising a frame having a floor platform (2) upon which floor plates are mounted and upon which computer equipment and power supply systems are supported, the floor platform (2) being formed from an arrangement of longitudinal and transversely extending "C" section steel beams (8,10,12,14,15), upright wall beams (4) extending from the periphery of the floor platform at spaced locations therefrom, upon which wall cladding in supported, roof beams extending between upper ends of the wall beams upon which roof cladding of the module is supported, wherein the floor platform (2) includes a pair of longitudinally extending side beams (8,10) extending along either side of the module, a pair of transversely extending end beams (12,14) at either end of the module and plurality of longitudinally spaced transversely extending support beams (15) extending between the side beams (8,10) and having lifting members (20) mounted in the ends of the transversely extending support beams (15), **characterised in that** a distal end of each lifting member (20) having an aperture defining a lifting eye (22) to which a lifting hook of a lifting frame can be attached, wherein each lifting member (20) is retractably mounted in an end of a respective support beam (15) to be moveable between an extended position, wherein the lifting eyes can be connected to a respective lifting hook of a lifting frame, and a retracted position, wherein the lifting members are located within the footprint of the module, wherein each support beam (15) has a C section having upper and lower flanges, each lifting member (20) comprises a metal plate dimensioned to fit between the upper and lower flanges of the respective support beam (15) within which the respective lifting member is mounted.

2. A module as claimed in claim 1, wherein a vertical slot (24) is provided in a rear wall of the respective side beam (4,6), aligned with a respective support beam (15) and through which the respective lifting member (20) extends.

3. A module as claimed in claim 2, wherein each lifting member (20) is supported in a series of longitudinally spaced steel guide plates (26,27,28,29), each guide plate having a respective slot (30) formed therein through which the respective lifting member (20) passes.

4. A module as claimed in claim 3, wherein an outermost guide plate (26) is mounted between the upper and lower flanges of the respective side beam (15) of the floor platform (2) at an outer side of the respective side beam (4,6).

5. A module as claimed in claim 3 or claim 4, wherein a plurality of longitudinally spaced inner guide plates (27,28,29) are mounted within the "C" shaped section of the respective support beam (15) adjacent the respective side beam (4,6).

6. A module as claimed in claim 5, wherein a stop pin (32) is provided adjacent an inner end of each lifting member, wherein that said stop pin (32) is located between an adjacent pair of inner guide plates (28,29) to delimit the extended and retracted positions of the respective lifting member (20) with respect to the respective support beam (15), the stop pin (32) abutting an outermost (28) of said adjacent pair of guide plates when it is extended position and the stop pin (32) abutting the innermost (29) of said adjacent pair of guide plates when the lifting member is in its retracted position.

7. A module as claimed in any preceding claim, wherein each lifting member (20) comprises a steel plate having a thickness of 25mm.

8. A module as claimed in any preceding claim, wherein the lifting members (20) do not project more than 210mm from the sides of the module when in their extended positions.

9. A module as claimed in any preceding claim, further comprising a lifting frame adapted to be located above the module and having lifting points in locations corresponding to the positions of the lifting members on the module, attachment straps terminating in lifting coupling extending from each lifting point of the lifting frame, said lifting couplings being adapted to be coupled to the lifting eyes of the lifting members when the lifting members are in their extended positions to permit the module be lifted.

## Patentansprüche

1. Transportierbares Rechenzentrumsmodul, umfassend einen Rahmen, der eine Bodenplattform (2) aufweist, auf der Bodenplatten montiert sind und auf der Computerausrüstung und Stromversorgungssysteme gestützt sind, wobei die Bodenplattform (2) aus einer Anordnung von sich längs und quer erstreckenden "C"-Profil-Stahlträgern (8, 10, 12, 14, 15), aufrechten Wandträgern (4), die sich von der Peripherie der Bodenplattform an beabstandeten Stellen davon erstrecken, auf denen die Wandverkleidung getragen wird, Dachträgern, die sich zwischen den oberen Enden der Wandträger erstrecken, auf denen die Dachverkleidung des Moduls gestützt ist, gebildet ist, wobei die Bodenplattform (2) ein Paar von sich längs erstreckenden Seitenträgern (8,10), die sich entlang jeder Seite des Moduls erstrecken, ein Paar von sich quer erstreckenden Endträgern (12, 14) an jedem Ende des Moduls und eine Vielzahl von längs beabstandeten, sich quer erstreckenden Stützträgern (15), die sich zwischen den Seitenträgern (8, 10) erstrecken und Hebeelemente (20) aufweisen, die in den Enden der sich quer erstreckenden Stützträger (15) montiert sind, **dadurch gekennzeichnet, dass** ein distales Ende jedes Hebeelements (20) eine Öffnung aufweist, die eine Hebeöse (22) definiert, an der ein Hebehaken eines Heberahmens befestigt werden kann, wobei jedes Hebeelement (20) zurückziehbar in einem Ende eines jeweiligen Stützträgers (15) montiert ist, um zwischen einer ausgestreckten Position, wobei die Hebeösen mit einem jeweiligen Hebehaken eines Heberahmens verbunden sein können, und einer eingefahrenen Position beweglich zu sein, wobei sich die Hebeelemente innerhalb der Grundfläche des Moduls befinden, wobei jeder Stützträger (15) ein C-Profil aufweist, das einen oberen und unteren Flansch aufweist, jedes Hebeelement (20) eine Metallplatte umfasst, die dimensioniert ist, um zwischen den oberen und unteren Flansch des jeweiligen Stützträgers (15) zu passen, innerhalb dessen das jeweilige Hebeelement montiert ist.

2. Modul nach Anspruch 1, wobei in einer Rückwand des jeweiligen Seitenträgers (4, 6) ein vertikaler Schlitz (24) bereitgestellt ist, der mit einem jeweiligen Stützträger (15) ausgerichtet ist und durch den sich das jeweilige Hebeelement (20) erstreckt.

3. Modul nach Anspruch 2, wobei jedes Hebeelement (20) in einer Reihe von längs beabstandeten Stahlführungsplatten (26, 27, 28, 29) gestützt ist, wobei jede Führungsplatte einen entsprechenden Schlitz (30) aufweist, der darin gebildet ist, durch den das jeweilige Hebeelement (20) passiert.

4. Modul nach Anspruch 3, wobei eine äußerste Führungsplatte (26) zwischen dem oberen und unteren Flansch des jeweiligen Seitenträgers (15) der Bodenplattform (2) an einer Außenseite des jeweiligen Seitenträgers (4, 6) montiert ist.

5. Modul nach Anspruch 3 oder 4, wobei eine Vielzahl von längs beabstandeten inneren Führungsplatten (27, 28, 29) innerhalb des "C"-förmigen Profils des jeweiligen Stützträgers (15) benachbart zu dem jeweiligen Seitenträger (4, 6) montiert sind.

6. Modul nach Anspruch 5, wobei ein Anschlagstift (32) benachbart zu einem inneren Ende jedes Hebeelements bereitgestellt ist, wobei sich dieser Anschlagstift (32) zwischen einem benachbarten Paar von inneren Führungsplatten (28, 29) befindet, um die ausgestreckte und eingefahrene Position des jeweiligen Hebeelements (20) in Bezug auf den jeweiligen Stützträger (15) zu begrenzen, wobei der Anschlagstift (32) an einer äußersten (28) des benachbarten Paares von Führungsplatten anliegt, wenn es in der ausgestreckten Position ist, und der Anschlagstift (32) an der innersten (29) des benachbarten Paares von Führungsplatten anliegt, wenn das Hebeelement in seiner eingefahrenen Position ist.

7. Modul nach einem der vorhergehenden Ansprüche, wobei jedes Hebeelement (20) eine Stahlplatte umfasst, die eine Dicke von 25 mm aufweist.

8. Modul nach einem der vorhergehenden Ansprüche, wobei die Hebeelemente (20), wenn sie in ihren ausgestreckten Positionen sind, nicht mehr als 210 mm von den Seiten des Moduls abstehen.

9. Modul nach einem der vorhergehenden Ansprüche, ferner umfassend einen Heberahmen, der angepasst ist, um sich über dem Modul zu befinden und Hebepunkte an Stellen aufzuweisen, die den Positionen der Hebeelemente auf dem Modul entsprechen, wobei Befestigungsbänder in einer Hebekupplung enden, die sich von jedem Hebepunkt des Heberahmens aus erstreckt, wobei die Hebekupplungen angepasst sind, um mit den Hebeösen der Hebeelemente gekoppelt zu sein, wenn die Hebeelemente in ihren ausgestreckten Positionen sind, um zu ermöglichen, dass das Modul angehoben wird.

## Revendications

1. Module de centre de données transportable comprenant un châssis ayant une plateforme de plancher (2) sur laquelle sont montées des plaques de plancher et qui supporte des équipements informatiques et des systèmes d'alimentation électrique, la plateforme de plancher (2) étant constituée d'un assemblage de poutres en acier à section en « C » se prolongeant longitudinalement et transversalement (8, 10, 12, 14, 15), de poutres murales verticales (4) se prolongeant depuis la périphérie de la plateforme de plancher à des emplacements espacés de celle-ci, sur lesquelles est supporté le revêtement mural, et de poutres de toiture se prolongeant entre les extrémités supérieures des poutres murales et supportant le revêtement de toiture du module, dans lequel la plateforme de plancher (2) comporte une paire de poutres latérales se prolongeant longitudinalement (8, 10) se prolongeant de chaque côté du module, une paire de poutres d'extrémité se prolongeant transversalement (12, 14) à chaque extrémité du module et une pluralité de poutres de support transversales (15) espacées longitudinalement, se prolongeant entre les poutres latérales (8, 10) et ayant des éléments de levage (20) montés aux extrémités des poutres de support se prolongeant transversalement (15), **caractérisé en ce qu'**une extrémité distale de chaque élément de levage (20) a une ouverture définissant un œillet de levage (22) auquel peut être fixé un crochet de levage d'un châssis de levage, dans lequel chaque élément de levage (20) est monté de manière rétractable à une extrémité d'une poutre de support respective (15) afin de pouvoir se déplacer entre une position prolongée, dans lequel les œillets de levage peuvent être reliés à un crochet de levage respectif d'un châssis de levage, et une position rétractée, dans lequel les éléments de levage sont situés à l'intérieur de l'empreinte du module, dans lequel chaque poutre de support (15) a une section en C ayant des ailes supérieures et inférieures, chaque élément de levage (20) comprend une plaque métallique dimensionnée pour s'adapter entre les ailes supérieures et inférieures de la poutre de support respective (15) à l'intérieur de laquelle l'élément de levage respectif est monté.

2. Module selon la revendication 1, dans lequel une fente verticale (24) est prévue dans une paroi arrière de la poutre latérale respective (4,6), alignée avec une poutre de support respective (15) et à travers laquelle l'élément de levage respectif (20) se prolonge.

3. Module selon la revendication 2, dans lequel chaque élément de levage (20) est supporté par une série de plaques de guidage en acier espacées longitudinalement (26,27,28,29), chaque plaque de guidage ayant une fente respective (30) formée à travers laquelle passe l'élément de levage respectif (20).

4. Module selon la revendication 3, dans lequel une plaque de guidage extérieure (26) est montée entre les brides supérieure et inférieure de la poutre latérale respective (15) de la plateforme de plancher (2) sur un côté extérieur de la poutre latérale respective (4,6).

5. Module selon la revendication 3 ou la revendication 4, dans lequel une pluralité de plaques de guidage intérieures espacées longitudinalement (27,28,29) sont montées dans la section en forme de « C » de la poutre de support respective (15) adjacente à la poutre latérale respective (4,6).

6. Module selon la revendication 5, dans lequel une goupille de blocage (32) est prévue à proximité d'une extrémité intérieure de chaque élément de levage, ladite goupille de blocage (32) étant située entre une paire adjacente de plaques de guidage intérieures (28, 29) pour délimiter les positions prolongées et rétractées de l'élément de levage respectif (20) par rapport à la poutre de support respective (15), la goupille de blocage (32) butant contre la plaque la plus extérieure (28) de ladite paire adjacente de plaques de guidage lorsque l'élément est en position prolongée et la goupille de blocage (32) butant contre la plaque la plus intérieure (29) de ladite paire adjacente de plaques de guidage lorsque l'élément de levage est en position rétractée.

7. Module selon une quelconque revendication précédente, dans lequel chaque élément de levage (20) comprend une plaque d'acier d'une épaisseur de 25 mm.

8. Module selon une quelconque revendication précédente, dans lequel les éléments de levage (20) ne dépassent pas de plus de 210 mm des côtés du module lorsqu'ils sont dans leurs positions étendues.

9. Module selon une quelconque revendication précédente, comprenant également un cadre de levage adapté pour être situé au-dessus du module et ayant des points de levage à des emplacements correspondant aux positions des éléments de levage sur le module, des sangles de fixation se terminant par un raccord de levage se prolongeant de chaque point de levage du cadre de levage, lesdits raccords de levage étant adaptés pour être couplés aux anneaux de levage des éléments de levage lorsque les éléments de levage sont dans leurs positions prolongées pour permettre le levage du module.
